# EUROPEAN PATENT SPECIFICATION

(11) **EP 2 483 462 B1**
(45) Date of publication and mention of the grant of the patent: **30.07.2014**
(21) Application number: 10766313.0
(22) Date of filing: 04.10.2010
(51) Int. Cl.: D04H 1/42, H05K 9/00

(54) **MAGNETIC WOVEN MATERIAL**
MAGNETISCHES VLIESMATERIAL
MATÉRIAU NON-TISSÉ MAGNÉTIQUE

(30) Priority: 02.10.2009 GB 0917257
(43) Date of publication of application: 08.08.2012
(73) Proprietor: Technical Fibre Products Limited, Kendal, Cumbria LA9 6PZ (GB)
(72) Inventor: JESCHKE, Michael, Kendal Cumbria LA9 7HU (GB)
(74) Representative: Atkinson, Peter Birch
(86) International application number: PCT/GB2010/001857
(87) International publication number: WO 2011/039521

(56) References cited:
- EP-A1- 1 978 798
- WO-A1-93/25063
- WO-A2-02/02686
- WO-A2-2004/110125
- US-A- 5 498 443
- US-A1- 2007 134 482

## Description

The present invention relates to a magnetic material, and a method of manufacture of such a material.

Magnetic materials (e.g. high magnetic permeability materials) are used in a variety of applications, such as within electrical motors and as magnetic shielding for electronic devices. Such materials are typically metal alloys (e.g. mu-metal and permalloy) comprising one or more of nickel, iron, copper and molybdenum. Accordingly these materials are rigid, requiring machining to form shaped components, with such machining having associated cost implications. Further, such materials have a large mass making them undesirable for light-weight applications.

A further high permeability magnetic material comprises a high magnetic permeability particulate suspended in a rubber material. A still further material which is available is supplied by 3M under the designation AB-5000. This material is described as an EMI absorber which consists of a polymer resin (with acrylic pressure - sensitive adhesive) filled with soft metal flakes. The material has application for magnetic shielding and is supplied in thicknesses of 0.1, 0.2, 0.3, 0.5 and 1.0 mm. These materials are however of a relatively "closed" structure so are difficult to infuse with additional materials (e.g. resins) to tailor mechanical properties.

It is an object of the invention to obviate or mitigate the above mentioned disadvantages.

According to a first aspect of the invention, there is provided a magnetic material comprising a non-woven matrix of fibres which have a coating of a magnetic metal or alloy and magnetic particles bonded to said non-woven matrix..

The magnetic material of the invention comprises a non-woven matrix which has been produced from fibres coated with a magnetic metal or alloy, and magnetic particles bonded to the non-woven fibre matrix.

According to a second aspect of the present invention there is provided a method of producing a magnetic material comprising preparing a non-woven fibre matrix from fibres coated with a magnetic metal or alloy, and bonding magnetic particles to the matrix.

Magnetic materials in accordance with the invention have a number of advantages arising from the fact that they comprise a non-woven fibre matrix comprised of fibres which have a coating of magnetic metal or alloy and magnetic particles bonded to the non-woven fibre matrix. In particular, the non-woven fibre matrix allows the material to be conformable which is an advantage for many applications, e.g. in surface engineering composite applications in the aerospace or automotive industries to deliver a smooth surface. Furthermore the magnetic properties of the material may be tailored by the type and/or amount of magnetic particles bonded to the non-woven fibre matrix and also by the type and/or thickness of the magnetic coating on the fibres. Additionally materials in accordance with the invention may be produced with a range of basis weights which may be tailored for the particular end use application of the material. On a related point, it is thus possible for materials in accordance with the invention to be lighter than prior art materials. A further advantage that may be mentioned is that the porous structure of the materials of the invention allows them to be fused with additional materials (e.g. resins), e.g. to enhance strength or other mechanical properties.

Materials in accordance with the invention are useful for providing magnetic shielding. Examples include use (for shielding) in medical devices and equipment, magnetic sensors for compassing in passenger automobiles, cell phones and hand-held GPS receivers, along with compassing and dead reckoning in vehicle, aircraft, marine and personal navigation.

The base non-woven fibre matrix may be produced by a conventional wet laying technique. In conventional manner, such a process may comprise the steps of:
(i) wet-laying a dispersion (preferably aqueous) of the fibres on to a water pervious support to form a sheet;
(ii) draining water from said sheet; and
(iii) drying sheet to produce the non-woven fibre matrix.

The non-woven fibre matrix may be one in which the fibres are held together by a cured binder.

The matrix may be produced as a 2-dimensional or 3-dimensional shape by a vacuum forming process.

Materials in accordance with the invention may be readily prepared by bonding the magnetic particles to a pre-formed non-woven fibre matrix. Any of a wide variety of conventional adhesive agents may be used for bonding the magnetic particles to the non-woven fibre matrix but it is particularly preferred to use a dispersion of a water-dispersible polymer. A suitable product is Eastman WD-30 which is an aqueous dispersion containing 30% by weight of an amorphous sulfopolyester. Further examples include styrene-based and acrylic polymers. For the purposes of this procedure, the magnetic particles may be dispersed in the dispersion of the adhesive/binding agent to produce a coating composition which is applied using conventional techniques to the base non-woven fibre matrix. Subsequently the coated matrix may be dried (e.g. using a conventional oven).

We do not however preclude the possibility of forming the material in accordance with the invention by wet-laying a dispersion of the fibres also containing the metal particles.

The magnetic particles are preferably provided as a uniform coating on one or both sides of the base non-woven matrix of fibres.

Magnetic materials in accordance with the invention will generally have a total basis weight (calculated as total weight of the non-woven fibre matrix plus magnetic particles divided by area) of 1 to 1000 gm⁻², and more preferably 2 to 500 gm⁻², e.g. 5 to 500 gm⁻². More preferably, the total basis weight will be in the range of 10 to 200 gm⁻² and most preferably 20 to 150 gm⁻². Typically the basis weight of the non-woven fibre matrix will be in the range 3 to 250 gm⁻² with a preferred sub-range of 5 to 100 gm⁻², most preferably 10 to 75 gm⁻², with the remainder of the total basis weight being provided by the magnetic particles and any binder used for bonding the magnetic particles to the non-woven fibre matrix. Typically the amount of magnetic particles will be in the range 5 to 300 gm⁻², preferably 5 to 100 gm⁻², of the non-woven fibre matrix.

The fibres that form the non-woven matrix have a coating of a magnetic metal or metal alloy. If a metal alloy is used then it will comprise at least one magnetic material and alloying elements to provide required properties (e.g. a particular conductivity). The magnetic metal or magnetic metal alloy may comprise one or more metals selected from iron, nickel, copper, cobalt, gadolinium, silver, gold, chromium, ruthenium, tin, zinc and manganese, provided that there is at least one magnetic metal. The coating preferably includes at least one ferromagnetic metal. It is particularly preferred that the metal coating comprises an iron-nickel alloy, for which purpose a wide range of nickel:iron ratios may be used although generally the ratio will be in the range 80:20 to 45:55. A nickel:iron ratio of 80:20 provides the highest saturation capability whereas a nickel:iron ratio of 45:55 provides the highest permeability.

It is particularly preferred that the coating is of a high magnetic permeability metal e.g. from 200 Hm⁻¹ for stainless steel to 30,000 Hm⁻¹ for mumetal.

A variety of different ("core") fibres (i.e. fibres that are coated with the magnetic material or alloy) may be used for forming the non-woven fibre matrix. The fibres may, for example, may be vitreous fibres or synthetic polymer fibres. Alternatively the non-woven fibre matrix may be comprised of carbon fibres which are advantageous since they do not expand significantly on heating (i.e. they have a very low thermal expansion which is mainly positive depending on the exact application).

Particularly preferred fibres for use in accordance with the invention comprise carbon fibres coated with an iron/nickel alloy thereby providing low thermal expansion with maximised magnetic properties for the material.

Irrespective of fibre type, the fibres of the non-woven matrix will generally have a length in the range 1-100 mm (preferably 3-25 mm) and a cross-sectional thickness of 4-15 µm.

It is preferred that all fibres that make up the non-woven matrix have a coating of magnetic metal or magnetic metal alloy but we do not preclude the possibility of the presence (in the matrix) of uncoated fibres. Generally at least 5% by weight of the fibres of the matrix will have a coating of the magnetic metal or metal alloy. More typically at least 50% of the fibres will have such a coating, more usually at least 75% and preferably at least 90%, the ideal being 100%.

The magnetic particles bonded to the non-woven fibre matrix will generally comprise at least one of iron, cobalt and nickel to impart ferromagnetic properties to the particle matrix. The particles may comprise more than one such ferromagnetic element and alternatively or additionally may incorporate alloying elements (such as chromium, manganese and/or molybdenum) usually in a total amount of somewhat less than the amount of ferromagnetic material present in the particles.

The magnetic particles will generally have size dimensions in the range 1 nm to 200µm, more preferably in the range 10 nm to 100µm and even more preferably in the range 1 to 20 µm as determined by a d₅₀ measurement light scattering technique typically by using an instrument such as a Malvern Mastersizer 2000. The particles may be "flake-like" as a result of the process by which the manufactured and as such have a thickness somewhat less than both their length and width. Typically the thickness of such "flake-like" particles will be in the range 10 nm to 20 µm with the length and width being up to 100 µm.

Magnetic particles which are particularly suitable for use in the invention are available from Silberline Manufacturing Co. Inc. under the following designations:
Stainless Steel Pigment RMT441
Stainless Steel Pigment RMT442
Stainless Steel Pigment RMT468

The above three products all comprise particulate iron alloy in Stoddart Solvent which is removed by washing (e.g. using 70920 Dowanol ® PM supplied by Kremer Pigmente) to render the particles suitable for use in producing composite materials in accordance with the invention. The '441 product comprises an alloy of iron and chromium, the '442 product comprises an alloy of iron, nickel, chromium, manganese and molybdenum, and the '468 product comprises an alloy of iron, chromium and nickel. Blends of two or more of these products may be used.

A further material that may be used s MRK 254 Stainless Steel Flake (also available from Silberline) which comprises 69% iron, 17% chromium, 12% nickel and 2% molybdenum (the percentages being by weight) and which may be milled or otherwise comminuted to an appropriate particle size for use in the invention.

The magnetic properties of materials in accordance with the invention may be tailored to a desired level in a number of ways, e.g.
(i) use of fibres with coatings that deliver required levels of magnetic properties;
(ii) use of magnetic particles with required levels of magnetic properties;
(iii) appropriate fibre: particle ratios;
(iv) particle size;
(v) fibre coating weight;
(vi) fibre orientation;
(vii) particle orientation; and/or
(viii) particle distribution within matrix.

With regard to (vi) an orientation of fibres with a magnetic coating may be effected/controlled by application of a magnetic field during the wet-laying process. By aligning the fibres it is possible to produce a denser structure for the non-woven matrix (particularly in the case where the fibres are carbon fibre - a relatively rigid material), thus influencing its magnetic properties. Similarly, with regard to (vii), orientation of magnetic particles may be controlled by use of a magnetic field during the step of applying the particles to the fibre matrix. Particle orientation is appropriate, for example, in the case where the particles are regular in structure or "flake like" such that, in the latter case, the flakes may be oriented in generally the same direction. Particle distribution (i.e. possibility (viii) above) may be effected by controlled drying of the non-woven web on or in which the particles have been incorporated. Thus, for example, drying the web at one side only will cause a preferential migration of particles to that side, which may be beneficial for the final magnetic properties of the material.

Magnetic materials in accordance with the invention may have a coercivity of 1 to 500,000 Oe, e.g. 1 to 10,000 Oe at ambient temperature. The material in accordance with the invention may be a "soft magnetic material" having a coercivity of 1 to 10 or a "hard magnetic material" having a coercivity of 1000 to 10,000.

The materials may have a magnetic permeability of 1 to 1000 Hm⁻¹.

The material may have a saturation magnetisation of 10 to 3000 emu/cm³ (preferably 1500 to 2000 emu/cm³). The material may have a saturation magnetisation of 1 to 500 emu g⁻¹, preferably 5 to 100 emu g⁻¹, even more preferably 20 to 40 emu g⁻¹.

The invention will be illustrated by the following non-limiting Examples and accompanying drawings, in which:
Fig 1 is a plot of saturation magnetisation *vs* basis weight for materials produced in accordance with Example 2;
Fig 2 is a plot coercivity vs basis weight for materials produced in accordance with Example 2; and
Fig 3 is a plot remnance vs basis weight for materials produced in accordance with Example 2.

### Example 1

This Example demonstrates the application of a coating of magnetic particles to a non-woven matrix comprised of nickel-coated carbon fibres having a length of 12 mm and diameter of 7 µm. The non-woven fibre matrix had a basis weight of 10g m⁻² and was prepared using a standard wet-laying technique such as used for the manufacture of paper.

A water-based dispersion with an overall solids content of 12.4% by weight was prepared from a mixture of the following components in the indicated amounts.

| **Component** | **Amount** |
|---|---|
| ¹SSP RMT441 | 100 g |
| SSP RMT442 | 100 g |
| SSP RMT468 | 50 g |
| Eastman WD-30 | 200 ml |
| Water | 2050ml |

| | |
|---|---|
| ¹ SSP = Stainless Steel Pigment | |

Prior to forming the dispersion, the SSPs were prepared by washing the Stoddard solvent out with 70920 Dowanol ® PM (supplied by Kremer Pigmente). The particles were then dried before adding to the other ingredients. The weights of the SSP products quoted in the above table are the weights of the washed and dried particles.

The dispersion was applied to the non-woven fibre matrix (comprised of nickel coated carbon fibres) at a rate of 690 g m⁻² using a laboratory coater. The non-woven matrix to which the dispersion had been applied was then dried in a oven.

The resulting product comprised the non-woven fibre matrix with a coating of 110 g m⁻² of metal particles and polymer binder (total basis weight = 120 g m⁻² including the non-woven fibre matrix).

The 110 g m⁻² coating comprised:

| **Component** | **Amount** |
|---|---|
| SSP RMT441 | 35.5 g m⁻² |
| SSP RMT442 | 35.5 g m⁻² |
| SSP RMT468 | 17.7 g m⁻² |
| Binder | 21.3 g m⁻² |

The material was found to have the following magnetic properties:

| **Magnetic Property** | **Value** |
|---|---|
| Coercivity | 33 Oe |
| Permeability | 100 Hm⁻¹ |
| Magnetisation | 70 emu/g |

### Example 2

This Example investigates the magnetic properties of various materials in accordance with the invention with the invention obtained by bonding magnetic particles to non-woven fibre matrices comprised of carbon fibres plated with nickel alloy coated carbon fibres. The fibres of the matrix had a length of 6 mm and diameter of 6-10 µm. Overall the fibres comprised 42-50% by weight of the alloy which itself had a composition of 80% nickel and 20% iron (reflecting a mumetal type material).

MRK 254 Stainless Steel Flake (ex Silberline) was milled and the resulting product used as the magnetic particles for this Example. Using a Mastersizer 2000 (Malvern Instruments) the particles were determined to have a specific surface area of 0.964 m²/g and have values for d(0.1), d(0.5) and d(0.9) by volume as follows:
d(0.1)= 3.148 µm
d(0.5) = 8.702 µm
d (0.9) = 20.159 µm

For the purposes of this Example, non-woven fibre matrices having basis weights of nominally 20, 30 and 40 gm⁻² were produced from the metal plated carbon fibres using conventional paper-making techniques.

Following the procedure of Example 1, the water based dispersion described therein (solids content = 12.4% by weight was used to produce materials in accordance with the invention with a range of coating weights from each of the three non-woven fibre matrices (basis weights nominally 20, 30 and 40 gm⁻²). The following Table shows details of the materials produced and their measured magnetic properties together (for comparison) with measured properties for AB-5000 (ex 3M) having a thickness of 0.5 mm.

| **Sample Number** | **Fibre basis weight - nominal [g/m²]** | **Weight of Binder [g/m²]** | **Weight of Magnetic Particles [g/m²]** | **Total Weight (measured [g/m²]** | **Ms [emu/ g]** | **Hc [Oe]** | **Mr [emu/g)** | **Hs [Oe]** | **Hclose [Oe]** |
|---|---|---|---|---|---|---|---|---|---|
| Control 1 | 20 | - | - | 20.36 | 22.6 | 20.39 | 5.04 | 520 | 303 |
| 9 | 20 | 11.54 | 7.24 | 38.78 | 22.17 | 31.31 | 5.28 | 900 | 1153 |
| 6 | 20 | 11.5 | 28.83 | 60.33 | 35.43 | 64.41 | 9.47 | 1035 | 1234 |
| 3 | 20 | 6.97 | 43.66 | 70.63 | 32.94 | 66.24 | 8.6 | 1034 | 1312 |
| | | | | | | | | | |
| Control 2 | 30 | - | - | 28.53 | 19.35 | 19.94 | 4.52 | 520 | 305 |
| 8 | 30 | 14.3 | 8.97 | 53.27 | 24.94 | 37.5 | 5.97 | 939 | 1120 |
| 5 | 30 | 11.72 | 29.37 | 71.09 | 32.19 | 50.66 | 8.45 | 1019 | 1258 |
| 2 | 30 | 8.62 | 54 | 92.62 | 32 | 63.47 | 7.65 | 904 | 1316 |
| | | | | | | | | | |
| Control 3 | 40 | - | - | 38.49 | 18.4 | 17.66 | 8.08 | 508 | 328 |
| 7 | 40 | 15.38 | 9.64 | 65.02 | 20.71 | 36.6 | 4.83 | 928 | 1147 |
| 4 | 40 | 14.33 | 35.92 | 90.25 | 32.04 | 63.44 | 8.27 | 1033 | 1312 |
| 1 | 40 | 12.85 | 80.55 | 133.4 | 33.54 | 64.71 | 8.26 | 1069 | 1347 |
| | | | | | | | | | |
| AB-5000 | | | | 626 | 87.5 | 7.8 | 6.6 | 688 | 276 |

In the above Table:
Ms (emu/g) is the saturation magnetisation;
He (Oe) is the Coercivity;
Mr (emu/g) is the Remnance;
Hs (Oe) is the saturation field; and
Hclose (Oe) is the closure field.

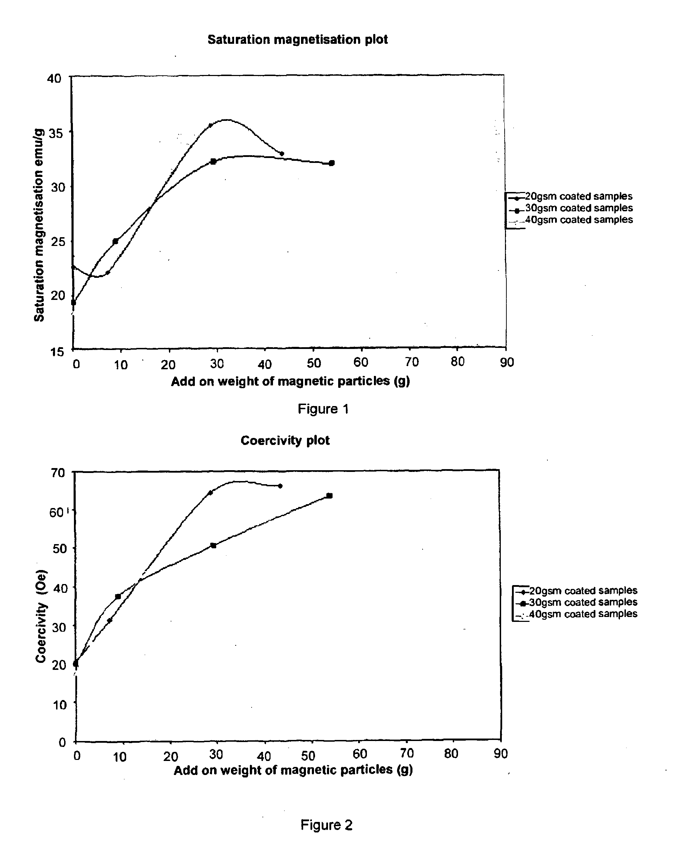

Reference is now made to Figs 1, 2 and 3 of the accompanying drawings which respectively plot saturation magnetisation, coercivity and remnance of the various products *vs* the "add on weight" of magnetic particles expressed in g/m² (i.e. the values shown in the fourth column of the above Table). For each of Figs 1, 2 and 3 the "add on weight" plotted is further identified by the basis weight of the original non-woven fibrous matrix. Thus each of Figs 1, 2 and 3 has (in effect) three sets points, i.e. for the 20 g/m², 30 g/m² and 40 g/m² materials.

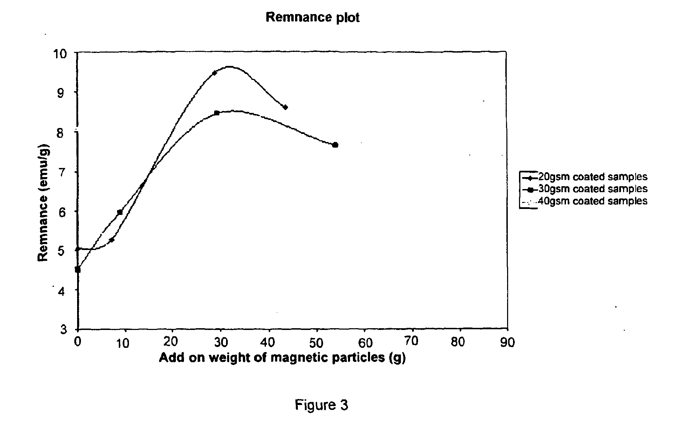

It can be seen from Fig 1 that saturation magnetisation increases with the "add on weight" of particles up to 30 g/m². At higher "add on weight" there was some reduction in saturation magnetisation in respect of the non-woven fibre matrix having an original basis weight of 20 g/m² whereas the value remains relatively constant in respect of the 30 and 40 g/m² samples. Similar effects were observed in respect of coercivity (Fig 2) and remnance (Fig 3).

## Claims

1. A magnetic material comprising a non-woven fibre matrix wherein fibres of the non-woven matrix have a coating of a magnetic metal or alloy and magnetic particles are bonded to said non-woven matrix.

2. A material as claimed in claim 1, wherein the fibres comprise at least one of carbon fibres, vitreous fibres and synthetic polymer fibres.

3. A material as claimed in claim 1 or 2, wherein the metal coating comprises nickel, an iron-nickel alloy or a copper-nickel alloy.

4. A material as claimed in any one of claims 1 to 3 wherein the particles have size dimensions in the range 1 nm to 200 µm.

5. A material as claimed in claim 4 wherein the particles have a thickness in the range 10 nm to 20 µm and a length and width up to 100 µm.

6. A material as claimed in any one of claims 1 to 5 wherein the magnetic particles are selected from particles comprising an alloy of iron and chromium, particles comprising an alloy of iron, nickel and chromium and mixtures thereof.

7. A material as claimed in any one of claims 1 to 6 having a total basis weight of 2 to 500 gm⁻².

8. A material as claimed in any one of claims 1 to 7 wherein the basis weight of the non-woven fibre matrix is in the range 3 to 250 gm⁻².

9. A material as claimed in any one of claims 1 to 8 which comprises 5 to 100 gm⁻² of magnetic particles.

10. A material as claimed in any one of claims 1 to 9 having coercivity range of 1 to 500,000 Oe at ambient temperature.

11. A material as claimed in any one of claims 1 to 10 having a magnetic permeability range of 1 to 1000 Hm⁻¹.

12. A material as claimed in any one of claims 1 to 11 having a Magnetisation range of 1 to 500 emu g⁻¹.

13. A method as producing a material as claimed in any one of claims 1 to 12 comprising bonding the magnetic particles to the non-woven matrix of fibres which has been preformed.

14. A method as claimed in claim 13 wherein the pre-formed non-woven matrix fibres has been produced by a wet-laying technique or by a vacuum forming technique.

15. A method of producing a material as claimed in any one of claims 1 to 12 comprising the steps of:
(i) wet-laying a dispersion (preferably aqueous) of the fibres on to a water pervious support to form a sheet or shape;
(ii) draining water from said sheet or shape;
(iii) drying sheet to produce the non-woven fibre matrix; and
(iv) bonding the magnetic particles to the non-woven fibre matrix.

## Patentansprüche

1. Magnetisches Material umfassend eine Vliesstofffasermatrix, wobei die Fasern der Vliesstoffmatrix eine Beschichtung aus einem magnetischen Metall oder einer magnetischen Legierung aufweisen und magnetische Teilchen auf die Vliesstoffmatrix bondiert sind.

2. Material nach Anspruch 1, wobei die Fasern mindestens eine von Kohlefasern, Glasfasern und synthetischen Polymerfasern umfassen.

3. Material nach Anspruch 1 oder 2, wobei die Metallbeschichtung Nickel, eine Eisen-Nickellegierung oder eine Kupfer-Nickellegierung umfasst.

4. Material nach einem der Ansprüche 1 bis 3, wobei die Teilchen Größendimensionen im Bereich von 1 nm bis 200 µm aufweisen.

5. Material nach Anspruch 4, wobei die Teilchen eine Dicke im Bereich von 10 nm bis 20 µm und eine Länge und Breite von bis zu 100 µm aufweisen.

6. Material nach einem der Ansprüche 1 bis 5, wobei die magnetischen Teilchen unter Teilchen, die eine Legierung von Eisen und Chrom umfassen, Teilchen, die eine Legierung von Eisen, Nickel und Chrom umfassen und Mischungen davon ausgewählt werden.

7. Material nach einem der Ansprüche 1 bis 6, das ein gesamtes Flächengewicht von 2 bis 500 g/m⁻2 aufweist.

8. Material nach einem der Ansprüche 1 bis 7, wobei das Flächengewicht der Vliesstofffasermatrix im Bereich von 3 bis 250 g/m⁻² liegt.

9. Material nach einem der Ansprüche 1 bis 8, das 5 bis 100 g/m⁻² magnetische Teilchen umfasst.

10. Material nach einem der Ansprüche 1 bis 9, das einen Koerzitivkraftbereich von 1 bis 500.000 Oe bei Umgebungstemperatur aufweist.

11. Material nach einem der Ansprüche 1 bis 10, das einen magnetischen Durchlässigkeitsbereich von 1 bis 1000 Hm⁻¹ aufweist.

12. Material nach einem der Ansprüche 1 bis 11, das einen Magnetisierungsbereich von 1 bis 500 emu g⁻¹ aufweist.

13. Verfahren zur Herstellung eines Materials nach einem der Ansprüche 1 bis 12, umfassend das Bondieren der magnetischen Teilchen an die Vliesstoffmatrix von Fasern, die vorgeformt worden ist.

14. Verfahren nach Anspruch 13, wobei die Fasern der vorgeformten Vliesstoffmatrix durch eine Nassauflegetechnik oder durch eine Vakuumformungstechnik hergestellt worden sind.

15. Verfahren zur Herstellung eines Materials nach einem der Ansprüche 1 bis 12, umfassend die Schritte des:
(i) Nassverlegens einer (bevorzugt wässrigen) Dispersion der Fasern auf einen wasserdurchlässigen Träger unter Bildung einer Platte oder eines Gebildes;
(ii) Abfließenlassen von Wasser von der Platte oder dem Gebilde,
(iii) Trocknen der Platte, um die Vliesstofffasermatrix herzustellen; und
(iv) Bondieren der magnetischen Teilchen an die Vliesstofffasermatrix.

## Revendications

1. Matériau magnétique comprenant une matrice de fibres non tissées dans lequel les fibres de la matrice non tissée ont un revêtement d'un métal ou d'un alliage magnétique et des particules magnétiques sont liées à ladite matrice non tissée.

2. Matériau tel que revendiqué selon la revendication 1, dans lequel les fibres comprennent au moins l'un parmi des fibres de carbone, des fibres vitreuses et des fibres polymères synthétiques.

3. Matériau tel que revendiqué selon la revendication 1 ou 2, dans lequel le revêtement métallique comprend du nickel, un alliage de fer-nickel ou un alliage de cuivre-nickel.

4. Matériau tel que revendiqué selon l'une quelconque des revendications 1 à 3 dans lequel les particules ont des dimensions de taille situées dans la plage de 1 nm à 200 µm.

5. Matériau tel que revendiqué selon la revendication 4, dans lequel les particules ont une épaisseur située dans la plage de 10 nm à 20 µm et une longueur et une largeur allant jusqu'à 100 µm.

6. Matériau tel que revendiqué selon l'une quelconque des revendications 1 à 5 dans lequel les particules magnétiques sont sélectionnées parmi les particules comprenant un alliage de fer et de chrome, les particules comprenant un alliage de fer, de nickel et de chrome et les mélanges de ceux-ci.

7. Matériau tel que revendiqué selon l'une quelconque des revendications 1 à 6 ayant un poids de base total de 2 à 500 g/m⁻².

8. Matériau tel que revendiqué selon l'une quelconque des revendications 1 à 7, dans lequel le poids de base de la matrice de fibres non tissées se situe dans la plage de 3 à 250 g/m⁻².

9. Matériau tel que revendiqué selon l'une quelconque des revendications 1 à 8 qui comprend 5 à 100 g/m⁻² de particules magnétiques.

10. Matériau tel que revendiqué selon l'une quelconque des revendications 1 à 9 ayant une plage de coercivité de 1 à 500 000 OE à la température ambiante.

11. Matériau tel que revendiqué selon l'une quelconque des revendications 1 à 10 ayant une plage de perméabilité magnétique de 1 à 1 000 Hm⁻¹.

12. Matériau tel que revendiqué selon l'une quelconque des revendications 1 à 11 ayant une plage de magnétisation de 1 à 500 emu g⁻¹.

13. Procédé de production d'un matériau tel que revendiqué selon l'une quelconque des revendications 1 à 12 comprenant la liaison des particules magnétiques à la matrice non tissée de fibres qui a été préformée.

14. Procédé tel que revendiqué selon la revendication 13, dans lequel les fibres de la matrice non tissée préformée ont été produites grâce à une technique de dépôt par voie humide ou grâce à une technique de formation sous vide.

15. Procédé de production d'un matériau tel que revendiqué selon l'une quelconque des revendications 1 à 12 comprenant les étapes de:
(i) dépôt par voie humide d'une dispersion (de préférence aqueuse) des fibres sur un support perméable à l'eau pour former une feuille ou une forme;
(ii) égouttage de l'eau de ladite feuille ou forme;
(iii) séchage de la feuille pour produire la matrice de fibres non tissées; et
(iv) liaison des particules magnétiques à la matrice de fibres non tissées.
